# EUROPEAN PATENT APPLICATION

(11) **EP 3 910 920 A1**
(43) Date of publication of application: **17.11.2021**
(21) Application number: 20771142.5
(22) Date of filing: 08.03.2020
(51) Int. Cl.: H04M 1/02, G06F 1/16

(54) **ELECTRONIC DEVICE**

(30) Priority: 08.03.2019 CN 201920295695 U
(71) Applicant: GUANGDONG OPPO MOBILE TELECOMMUNICATIONS CORP., LTD., Dongguan, Guangdong 523860 (CN)
(72) Inventor: BAO, Xiaoming, Dongguan, Guangdong 523860 (CN)
(74) Representative: Thorniley, Peter
(86) International application number: PCT/CN2020/078339
(87) International publication number: WO 2020/182089

(57) **Abstract**

An electronic device, comprising: a housing, a screen flexible circuit board, and a COF flexible circuit board. The housing is provided with a battery groove for accommodating a battery. The screen flexible circuit board is disposed on one side, close to the bottom of the housing, of the battery groove. The COF flexible circuit board is disposed on one side, close to the bottom of the housing, of the screen flexible circuit board. The COF flexible circuit board is provided with a through hole used for mounting a biological feature recognizer, and the through hole is located below the battery groove. The electronic device can provide enough space to facilitate battery mounting. The through hole is formed in the COF flexible circuit board closer to the bottom of the housing, and the through hole is closer to the bottom of the housing. According to the electronic device, the length of the mounted battery can be increased, the battery capacity of the long battery is large, and user experience is improved.

## Description

### FIELD

The present disclosure relates to an electronic device.

### BACKGROUND

Currently, "full screen" prevails in the field of smartphones, so that numerous new products have a broader field of view while maintaining the same size. "Screen-to-body ratio" has become a battlefield for future new products. Packaging technology used in smartphone screens has become the key to victory in this battle.

In order to solve the problem of full-screen fingerprint unlocking, an under-screen fingerprint recognition device is installed in a middle and lower part of a smartphone screen. Currently, the under-screen fingerprint recognition device is usually installed on a screen flexible circuit board, so that the under-screen fingerprint recognition device is closer to the top. The under-screen fingerprint recognition device cannot be covered by a battery of the smartphone, which limits a length of the battery and affects a battery capacity of the smartphone.

### SUMMARY

The purpose of the present disclosure is to provide an electronic device that can provide sufficient space to install a longer battery therein, thereby improving battery capacity.

The present disclosure provides an electronic device including a casing, a screen flexible circuit board, and a chip on film (COF) flexible circuit board. The casing has a battery slot for accommodating a battery. The screen flexible circuit board is disposed on a side of the battery slot close to a bottom of the casing. The COF flexible circuit board is disposed on a side of the screen flexible circuit board close to the bottom of the casing. The COF flexible circuit board is provided with a through hole for installing a biometric identifier. The through hole is located between the battery slot and the bottom of the casing.

In the electronic device, the through hole for installing the biometric identifier is located on the COF flexible circuit board closer to the bottom of the casing, so that the through hole is closer to the bottom of the casing. Therefore, the battery slot of the electronic device has a longer length, so that a longer battery can be installed, which increases battery capacity of the electronic device and improves user experience.

### BRIEF DESCRIPTION OF DRAWINGS

FIG. 1 is a perspective view of an electronic device according to an embodiment of the present disclosure.
FIG. 2 is a perspective view of the electronic device of Fig. 1 provided with a battery.
FIG. 3 is a schematic structural diagram of the electronic device of FIG. 1.
FIG. 4 is an exploded view of the electronic device of FIG. 3.
FIG. 5 is a cross-sectional view of the electronic device of FIG. 3.

Reference numerals in the accompanying drawings are described as follows: 11, casing; 111, battery slot; 12, screen flexible circuit board; 121, main body part; 122, extension arm; 123, connecting part; 124, binding area; 125, stepped part; 126, mounting surface; 13, chip on film (COF) flexible circuit board; 131, body portion; 132, extension portion; 133, binding portion; 134, through hole; 135, bent portion; 14, connector; 15, screen; 151, upper substrate 152, lower substrate; 16, buffer layer; 17, main board; 18, chip; 19, touch panel (TP) flexible circuit board; 10, biometric identifier; and 20, battery.

### DETAILED DESCRIPTION

While the present invention may easily be embodied in different embodiments, only some specific embodiments of the embodiments are illustrated in the accompanying drawings and are described in detail in the present specification. It can be understood that the present specification should be regarded as an exemplary description of principles of the present invention, and is not intended to limit the present invention to what is described herein.

Therefore, a feature pointed out in the present specification is used to describe one of features of an embodiment of the present invention, rather than implying that each embodiment of the present invention must have the described feature. Furthermore, it should be noted that the present specification describes many features. While certain features may be combined to illustrate possible system designs, these features may also be used in other combinations that are not explicitly described. Thus, unless otherwise stated, the illustrated combinations are not intended to be limiting.

In the embodiments illustrated in the accompanying drawings, representations of directions such as up, down, left, right, front, rear, top, and bottom, used for explaining structure and movement of various elements of the present invention, are not absolute, but relative. These representations are appropriate when the elements are in the position shown in the accompanying drawings. If description of the position of the elements changes, these representations are to be changed accordingly.

Exemplary embodiments will now be described more fully with reference to the accompanying drawings. The exemplary embodiments may be implemented in various forms and should not be construed as being limited to examples described herein. The exemplary embodiments are provided to make description of the present invention more comprehensive and complete, and fully convey the concept of the exemplary embodiments to those skilled in the art. The accompanying drawings are only intended to schematically illustrate the present invention and are not necessarily drawn to scale. Same reference numerals represent same or similar parts in the accompanying drawings, and repetitions thereof will be omitted.

Preferred embodiments of the present invention will be further described in detail below in conjunction with the accompanying drawings in the present specification.

The present disclosure provides an electronic device. The electronic device may be an electronic apparatus with an under-screen biometric identifier, such as a mobile phone or a tablet computer. Specifically, in the embodiments, the electronic device is described by taking a mobile phone as an example, and other electronic apparatus will not be described.

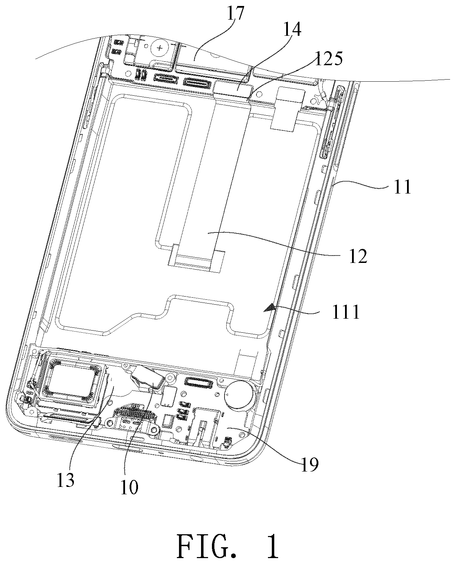

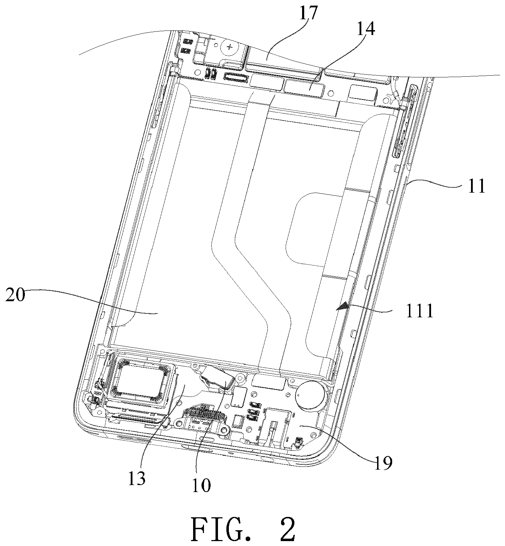

Please refer to FIG. 1 and FIG. 2, the electronic device of this embodiment includes a casing 11, a screen flexible circuit board 12, and a chip on film (COF) flexible circuit board 13. For convenience of description, the casing 11 is shaped as a rectangle. A long side direction of the casing 11 is a longitudinal direction of the casing 11, and a short side direction of the casing 11 is a transverse direction of the casing 11. A top and a bottom of the casing 11 are two ends of the casing 11 in the longitudinal direction.

The screen flexible circuit board 12 and the COF flexible circuit board 13 are both disposed at the bottom of the casing 11. COF flexible circuit board is an abbreviation of chip on flex or chip on film flexible circuit board. The COF flexible circuit board 13 is disposed on a side of the screen flexible circuit board 12 close to the bottom of the casing 11.

The COF flexible circuit board 13 is provided with a through hole 134 for installing a biometric identifier 10. The casing 11 has a battery slot 111 for accommodating a battery 20. The through hole 134 is located below the battery slot 111. The through hole 134 is located on the COF flexible circuit board closer to the bottom of the casing 11, so that the through hole is closer to the bottom of the casing 11. Therefore, the battery slot 111 of the electronic device has a longer length, so that the longer battery 20 can be installed therein, which increases a capacity of the battery 20 of the electronic device and improves user experience of the electronic device.

Specifically, in this embodiment, the top of the casing 11 is provided with a main board 17. The bottom of the casing 11 is provided with the biometric identifier 10 for performing biometric recognition. The biometric identifier 10 may be configured to recognize biometrics such as fingerprints, pupils, and faces. Specifically, in this embodiment, the biometric identifier 10 may be a fingerprint identifier.

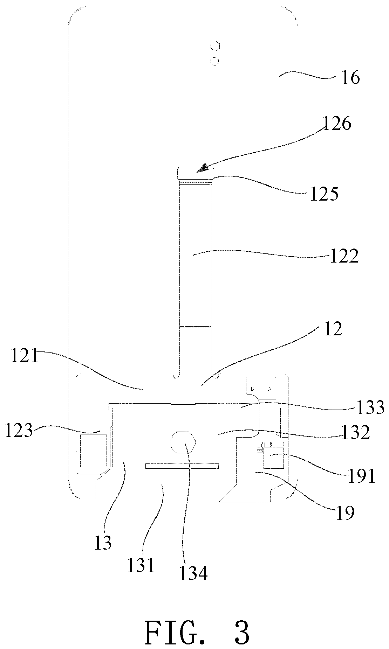

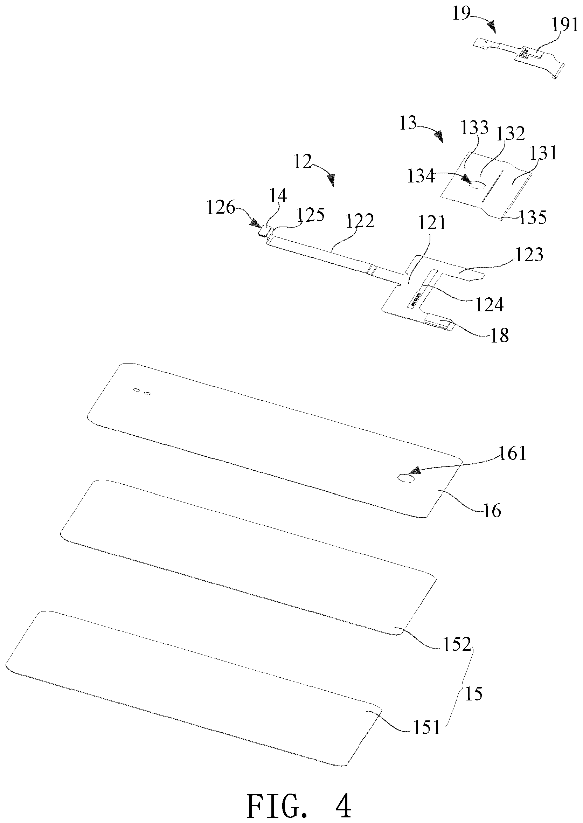

Please refer to FIG. 3 and FIG. 4, the screen flexible circuit board 12 may be a liquid crystal display (LCD) flexible circuit board. The screen flexible circuit board 12 is disposed on a side of the battery slot 111 close to the bottom of the casing 11. The screen flexible circuit board 12 is configured to dispose other components, such as a chip for controlling a display screen.

The screen flexible circuit board 12 comprises a main body part 121. The main body part 121 may be shaped as a rectangle.

A side of the main body part 121 close to the top of the casing 11 is provided with an extension arm 122. The extension arm 122 extends along a bottom surface of the battery slot 111 to the top of the casing 11. The extension arm 122 may penetrate the battery slot 111, and a top end of the extension arm 122 extends to a top of the battery slot 111. The top end of the extension arm 122 extending toward the top of the battery slot 111 is provided with a stepped part 125. The stepped part 125 has a mounting surface 126 for mounting a connector 14. The mounting surface 126 is higher than the bottom surface of the battery slot 111.

The connector 14 is configured to connect with the main board 17 to realize electrical signal connection between the screen flexible circuit board 12 and the main board 17. The stepped part 125 can raise the mounting surface 126 of the connector 14, so that the connector 14 can be installed outside the battery slot 111 to facilitate the connection between the connector 14 and the main board 17. Therefore, the extension arm 122 and the stepped part 125 can prevent the connector 14 from being located at the bottom of the casing 11, which prevents the connector 14 from interfering with a battery cover (not shown) and affecting installation of the battery 20.

The main body part 121 is provided with connecting parts 123 protruding toward the COF flexible circuit board 13. The connecting parts 123 are located below the battery slot 111, so that the connecting parts 123 and the battery 20 are staggered. The connecting parts 123 and electronic elements disposed thereon may not overlap with the battery 20, so as to prevent the connecting parts 123 from interfering with the battery 20.

Specifically, a number of the connecting parts 123 may be two. The two connecting parts may be individually configured to dispose elements such as chips. The two connecting parts 123 are disposed on two opposite sides of the COF flexible circuit board 13. The two connecting parts123 are disposed oppositely, so that an end of the screen flexible circuit board 12 close to the COF flexible circuit board 13 is shaped as an inverted U.

It can be understood that in other embodiments, the number of connecting parts 123 may also be one, three, four, or more. The number and spatial distribution of the connecting parts 123 are limited by a space inside the mobile phone. Therefore, the number and distribution positions of the connecting parts 123 may be designed according to the space inside the mobile phone.

The electronic device further comprises a touch panel (TP) flexible circuit board 19. The TP flexible circuit board 19 is bound to one of the connecting parts 123. The TP flexible circuit board 19 is provided with a TP chip 191. The TP flexible circuit board 19 is located below the battery slot 111. Therefore, the TP flexible circuit board 19 does not interfere with the longer battery 20, which ensures that the electronic device can be installed with the longer battery 20.

The main body part 121 is provided with a binding area 124 located between the two connecting parts 123. The binding area 124 is configured to bind the COF flexible circuit board 13. It can be understood that glue can be coated on the binding area 124 to bind the screen flexible circuit board 12 and the COF flexible circuit board 13.

The COF flexible circuit board 13 may be shaped as a rectangle. The COF flexible circuit board 13 is disposed on the side of the screen flexible circuit board 12 close to the bottom of the casing 11. The COF flexible circuit board 13 is provided with the through hole 134 for installing the biometric identifier . The through hole 134 is located below the battery slot 111. Therefore, the biometric identifier 10 installed in the through hole 134 is also located below the battery slot 111, which can prevent the biometric identifier 10 from interfering with the battery 20.

Specifically, in this embodiment, the COF flexible circuit board 13 is disposed between the two connecting parts 123. The two connecting parts 123 are respectively disposed on the two opposite sides of the COF flexible circuit board 13. The connecting parts 123 do not overlap the COF flexible circuit board 13, and the connecting parts 123 and the COF flexible circuit board 13 are both located below the battery slot 111, which facilitates electronic layout on the connecting portion 123.

Specifically, the COF flexible circuit board 13 comprises a body portion 131, an extension portion 132, and a binding portion 133. The extension portion 132 is located between the body portion 131 and the binding portion 133. The COF flexible circuit board 13 is divided into the body portion 131, the extension portion 132, and the binding portion 133 in the longitudinal direction of the casing 11.

The body portion 131 is close to the bottom of the casing 11. The body portion 131 is configured to dispose a chip 18. The body portion 131 is located below the battery slot 111, so that the chip 18 disposed on the body portion 131 will not interfere with the battery 20.

The binding portion 133 is disposed close to the screen flexible circuit board 12. The binding portion 133 is configured to bind the screen flexible circuit board 12. The binding portion 133 is aligned with the binding area 124 of the screen flexible circuit board 12. The binding portion 133 is bound to the binding area 124 of the screen flexible circuit board 12.

It can be understood that a shape and an area size of the binding portion 133 correspond to a shape and an area size of the binding area 124. The binding portion 133 only needs to be stably connected to the binding area 124 to realize electrical connection between the COF flexible circuit board 13 and the screen flexible circuit board 12. Specifically, in this embodiment, the binding area 124 is shaped as a rectangle, and the binding portion 133 is also shaped as a rectangle.

The extension portion 132 is located between the body portion 131 and the binding portion 133. The extension portion 132 is provided with the through hole 134 for installing the biometric identifier 10. The extension portion 132 is disposed on an outside of the bottom of the battery slot 111. A distance between the through hole 134 and the top of the battery slot 111 is greater than or equal to a length of the battery 20, so that the battery and the through hole 134 are staggered. Therefore, the biometric identifier 10 installed in the through hole 134 is prevented from interfering with the mobile phone and affecting normal installation of the mobile phone.

Specifically, in this embodiment, the two connecting parts 123 are disposed on opposite sides of the extension portion 132. The connecting parts 123 and the extension portion 132 are on a same plane to keep an internal layout of the mobile phone compact.

Specifically, in this embodiment, the electronic device further comprises a screen 15. The screen 15 is disposed on a side of the casing 11. The screen 15 may comprise an upper substrate 151 and a lower substrate 152. The lower substrate 152 is disposed on a side of the screen 15 close to the battery 20, and the upper substrate 151 is disposed on a side of the screen 15 away from the battery 20. It can be understood that the upper substrate 151 and the lower substrate 152 may be glass substrates, polycarbonate (PC) substrates, or the like.

An end of the body portion 13 of the COF flexible circuit board 13 away from the binding portion 133 is provided with a bent portion 135. The bent portion 135 is bent toward the screen 15 and is connected to an outer edge of the screen 15. The COF flexible circuit board 13 is fixedly connected to the screen 15 through the bent portion 135. Specifically, the bent portion 135 is bound and fixed to an edge of the lower substrate 152.

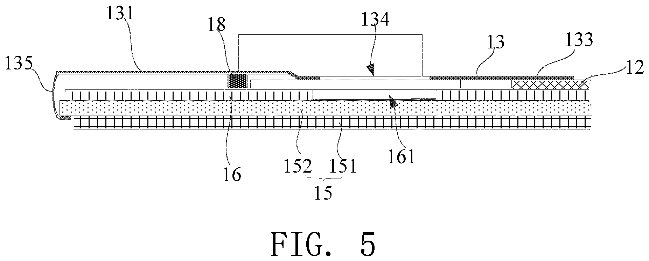

Please refer to FIG. 4 and FIG. 5. Specifically, in this embodiment, the electronic device further comprises a buffer layer 16. The buffer layer 16 is provided with an opening 161. The opening 161 is aligned with the through hole 134. A center of the opening 161 is aligned with a center of the through hole 134 to prevent fingerprint signals from being blocked by the buffer layer 16. Specifically, the buffer layer 16 may be foam.

In the electronic device, the COF flexible circuit board 13 comprises the extension portion 132. The through hole 134 is opened on the extension portion 132 between the body portion 13 and the binding portion 133 of the COF flexible circuit board 13, so that the biometric identifier 10 is closer to a bottom of the screen. Therefore, in a layout of the COF flexible circuit board 13, under the premise of not affecting overall circuit distribution, the through hole 134 will not interfere with the battery, thereby preventing the biometric identifier 10 from affecting the length of the battery. The electronic device can increase the length of the installed battery, and the longer battery has a larger battery capacity, which improves the user experience.

In addition, electrical elements such as the liquid crystal display (LCD) chip of the screen flexible circuit board 12 and the touch panel (TP) chip are moved down to positions below the screen fingerprint opeining, thereby preventing the elements at the bottom of the screen flexible circuit board 12 from interfering with the battery and affecting a length setting of the battery 20. Therefore, the designed length of the battery 20 can be as long as possible, and the installation of the battery 20 will not interfere with the screen biometric identifier 10, so that the capacity of the battery 20 can be increased, and a thickness of the battery 20 can be reduced, thereby facilitating development of light and thin mobile phone.

Although the present invention has been described with reference to several exemplary embodiments, it should be understood that the terms used herein are illustrative and exemplary rather than restrictive. Since the present invention may be implemented in various forms without departing from the spirit or essence of the present invention, it should be understood that the above embodiments are not limited to any of the foregoing details, and should be interpreted broadly within the spirit and scope defined by the appended claims. Therefore, all changes and modifications falling within the scope of the claims or their equivalents should be encompassed by the appended claims.

## Claims

1. An electronic device, comprising:
a casing having a battery slot for accommodating a battery;
a screen flexible circuit board disposed on a side of the battery slot close to a bottom of the casing; and
a chip on film ,COF, flexible circuit board disposed on a side of the screen flexible circuit board close to the bottom of the casing, wherein the COF flexible circuit board is provided with a through hole for installing a biometric identifier, and the through hole is located below the battery slot.

2. The electronic device as claimed in claim 1, **characterized in that** the COF flexible circuit board comprises:
a body portion disposed at the bottom of the casing and configured to carry a chip; and
an extension portion disposed on a side of the body portion, wherein the through hole is located in the extension portion.

3. The electronic device as claimed in claim 2, **characterized in that** the COF flexible circuit board further comprises:
a binding portion disposed on a side of the extension portion and configured to bind the screen flexible circuit board.

4. The electronic device as claimed in claim 3, further comprising a screen, wherein the COF flexible circuit board further comprises a bent portion disposed on a side of the body portion of the COF flexible circuit board away from the binding portion, and the bent portion is bent toward the screen and is bound to an outer edge of the screen.

5. The electronic device as claimed in claim 4, **characterized in that** the screen comprises:
an upper substrate disposed away from the battery; and
a lower substrate disposed close to the battery, wherein the bent portion is bound to an edge of the lower substrate.

6. The electronic device as claimed in claim 1, **characterized in that** the screen flexible circuit board comprises:
a main body part; and
connecting parts protruding from the main body part to the COF flexible circuit board and located below the battery slot.

7. The electronic device as claimed in claim 6, **characterized in that** a number of the connecting parts is two, and the two connecting parts are disposed on opposite sides of the COF flexible circuit board.

8. The electronic device as claimed in claim 7, **characterized in that** the main body part is provided with a binding area, wherein the binding area is located between the two connecting parts and is configured to bind the COF flexible circuit board.

9. The electronic device as claimed in claim 6, further comprising:
a touch panel ,TP, flexible circuit board bound to the connecting parts.

10. The electronic device as claimed in claim 1, **characterized in that** an end of the screen flexible circuit board close to the COF flexible circuit board is shaped as an inverted U.

11. The electronic device as claimed in claim 1, **characterized in that** the screen flexible circuit board further comprises an extension arm disposed on its side close to a top of the casing, the extension arm extends along a bottom surface of the battery slot to the top of the casing, the extension arm is provided with a connector, and the connector is configured to connect with a main board.

12. The electronic device as claimed in claim 11, **characterized in that** a free end of the extension arm is provided with a stepped part, the stepped part has a mounting surface for mounting the connector, and the mounting surface is higher than the bottom surface of the battery slot.

13. The electronic device as claimed in claim 4, further comprising a buffer layer disposed on a side of the screen close to the battery, **characterized in that** the buffer layer is provided with an opening, and the opening is aligned with the through hole.
